(19) Europäisches Patentamt
European Patent Office
Office européen des brevets

(11) Veröffentlichungsnummer : **0 470 049 A2**

(12) # EUROPÄISCHE PATENTANMELDUNG

(21) Anmeldenummer : **91810602.2**

(22) Anmeldetag : **26.07.91**

(51) Int. Cl.[5] : **B32B 15/06,** B32B 27/34, H05K 1/00

(30) Priorität : **03.08.90 CH 2539/90**

(43) Veröffentlichungstag der Anmeldung : **05.02.92 Patentblatt 92/06**

(84) Benannte Vertragsstaaten : **AT BE CH DE ES FR GB IT LI NL SE**

(71) Anmelder : **CIBA-GEIGY AG
Klybeckstrasse 141
CH-4002 Basel (CH)**

(72) Erfinder : **Pfaendner, Rudolf, Dr.
Sackgasse 3
W-6149 Rimbach/Odenwald 1 (DE)**
Erfinder : **Kainmüller, Thomas, Dr.
Kümmelberg 1
W-6145 Lindenfels/Odenwald (DE)**
Erfinder : **Scharf, Wolfgang, Dr.
Röttler Ring 11 c
W-7889 Grenzach-Wyhlen (DE)**
Erfinder : **Haug, Theobald, Dr.
Unt. Flühackerstrasse 12
CH-4402 Frenkendorf (CH)**
Erfinder : **Pfeifer, Josef, Dr.
Brunnmattstrasse 32
CH-4106 Therwil (CH)**
Erfinder : **Diethelm, Hermann, Dr.
Grottenweg
CH-1735 Giffers (CH)**

(54) **Mehrschichtlaminate.**

(57) Mehrschichtlaminate bestehend aus mindestens zwei Metallfolien, die direkt durch eine Polymerschicht eines Polyamidpolyimid(PA-PI)-Blockcopolymeren verbunden sind, eignen sich zur Herstellung von flexiblen elektronischen Schaltungen.

EP 0 470 049 A2

Die vorliegende Erfindung betrifft Mehrschichtlaminate auf Basis von Polyamid-Polyimid(PA-PI)-Blockcopolymeren, Verfahren zu ihrer Herstellung und die Verwendung der Mehrschichtlaminate zur Herstellung von elektronischen Schaltungen.

Mehrschichtlaminate sind bekannt und werden vorzugsweise zur Herstellung von elektronischen Schaltungen verwendet. Die aus dem Journal of Materials Science 24 (1989), Seiten 2183-2190, bekannten und im Handel beispielsweise unter der Bezeichnung Pyralux® erhältlichen Mehrschichtlaminate bestehen aus Kupferfolien und vorzugsweise aus einer Polyimidfolie, wobei mindestens zwei Kupferfolien durch eine Polyimidfolie verbunden sind und im einfachsten Fall der Aufbau Kupferfolie-Polyimidfolie-Kupferfolie vorliegt. Polyimidfolien zeigen jedoch eine zu geringe Haftung auf den verwendeten Kupferfolien und werden daher mittels eines Klebstoffes, beispielsweise auf Acrylat- oder Epoxidharzbasis, auf die Kupferfolie kaschiert. Aufgrund dieser notwendigen Klebstoffzwischenschicht weisen derartige Mehrschichtlaminate Nachteile auf, insbesondere ist die Haftung der Kupferfolie bei hohen Temperaturen stark erniedrigt.

Ein direkter Kupfer-Polyimid-Verbund kann beispielsweise erhalten werden, indem eine Kupferfolie mit der entsprechenden Polyamidsäure als lösung in einem organischen Lösungsmittel beschichtet wird, die anschliessend auf der Kupferfolie imidisiert wird. Diese beschichteten Materialien sind aber nicht zu Mehrschichtlaminaten direkt verpressbar. In der EP-A-0167 020 wird deshalb vorgeschlagen, solche Kupfer-Polyimid-Verbunde mittels einer heisssiegelbaren Polyimidschicht zu verbinden. Diese Mehrschichtlaminate erreichen bei Raumtemperatur jedoch nicht die Haftfestigkeitswerte wie sie bei den geklebten Polyimid-Kupferlaminaten erreicht werden.

Aus den EP-Patenten 48 219 und 48 221 sind ferner einfache, klebstofffreie Laminate auf Basis von PA-PI-Blockcopolymeren bekannt, die durch Beschichtung einer Kupferfolie mit einer Lösung eines Polyamid-Polyamidsäure-Blockcopolymeren und nachfolgender Imidisierung auf der Kupferfolie erhalten werden. Die Herstellung eines Mehrschichtlaminates wird in diesen Patenten nicht beschrieben.

Es wurde nun gefunden, dass sich klebstofffreie, mit Polyamid-Polyimid-Blockcopolymeren beschichtete Metallfolien durch direktes Verpressen miteinander oder mit einer unbeschichteten Metallfolie auf einfache Weise zu flexiblen, klebstofffreien Mehrschichtlaminaten verarbeiten lassen.

Gegenstand vorliegender Erfindung sind somit flexible, klebstofffreie Mehrschichtlaminate bestehend aus mindestens zwei Metallfolien, direkt verbunden durch mindestens eine Schicht eines Polyamid-Polyimid(PA-PI)-Blockcopolymeren.

Als Metallfolie können die erfindungsgemässen Mehrschichtlaminate beispielsweise solche aus Kupfer, Messing, Aluminium, Eisen oder Stahl enthalten. Vorzugsweise enthalten die erfindungsgemässen Mehrschichtlaminate Kupferfolien.

Unter PA-PI-Blockcopolymeren, die in den erfindungsgemässen Mehrschichtlaminaten enthalten sind, sind Verbindungen zu verstehen, die aus Polyamid- und Polyimidblöcken, aus Polyamidimid- und Polyimidblöcken oder aus Polyamid-, Polyamidimid- und Polyimidblöcken aufgebaut sind. Solche Verbindungen und Verfahren zu deren Herstellung sind bekannt, beispielsweise aus DE-A-2 342 464, DE-A-2 342 454, DE-A-2 366 273, EP-A-0 048 219, EP-A-0 048 221 oder EP-A-0 134 752. Die dort offenbarten Blockcopolymeren enthalten wiederkehrende Strukturelemente der Formel I

$$-\!\!\left[\text{PA-PI}\right]_{n}\!\!- \qquad \text{(I)},$$

worin n eine ganze Zahl von 1 bis 500, PA einen Polyamidblock mit einem mittleren Molekulargewicht von 350 bis 30'000 und PI einen Polyimidblock mit einem mittleren Molekulargewicht von 750 bis 2'000 darstellen, und weisen im allgemeinen eine inhärente Viskosität von 0,1 bis 2,5, insbesondere 0,4 bis 1,5 auf, gemessen an einer 0,5%-igen Lösung der als Vorstufe vorliegenden Polyamid-Polyamidsäure in N-Methylpyrrolidon bei 25 °C. Die in der oben angegebenen Literatur beschriebenen PA-PI-Blockcopolymeren werden durch Cyclisierung (Imidisierung) der entsprechenden, noch löslichen Polyamid-Polyamidsäure-Blockcopolymeren erhalten und können für die Herstellung der erfindungsgemässen Mehrschichtlaminate verwendet werden.

Vorzugsweise enthalten die erfindungsgemässen Mehrschichtlaminate als PA-PI-Blockcopolymere solche, die vor der Applikation noch löslich sind und nach der Applikation in kurzer Zeit bei verhältnismässig niedrigen Reaktionstemperaturen eine lösungsmittelstabile Beschichtung liefern, wobei gleichzeitig die guten mechanischen Eigenschaften des Polymeren weitgehend erhalten bleiben.

Unter dem Begriff "lösliches PA-PI-Blockcopolymer" ist im allgemeinen ein in polaren aprotischen Lösungsmitteln lösliches Copolymer zu verstehen, aus dem sich Lösungen enthaltend mindestens 5 Gew.%, insbesondere mindestens 10 Gew.%, an PA-PI-Blockcopolymer, bezogen auf die Lösung, herstellen lassen.

Dafür geeignete aprotische Lösungsmittel sind beispielsweise N,N-Dimethylacetamid, N,N-Diethylacetamid, N,N-Dimethylformamid, N,N-Dimethylmethoxyacetamid, N-Methyl-2-pyrrolidon, N-Acetyl-2-pyrrolidon, N-Methyl-ε-caprolactam, N,N,N',N'-Tetramethylharnstoff, Tetrahydrothiophendioxid (Sulfolan), Dimethylsulfoxid

und γ-Butyrolacton.

In einem polaren aprotischen Lösungsmittel lösliche PA-PI-Blockcopolymere sind bekannt, beispielsweise aus der EP-A-324 315. Bevorzugt für die erfindungsgemässen Mehrschichtlaminate sind Blockcopolymere des Typs A mit einem mittleren Molekulargewicht $\overline{M}_n$ von 1'000 bis 50'000 und wiederkehrenden Einheiten der Formel II

$$\{PA\text{-}PI\} \qquad (II)$$

worin PA für einen Polyamidblock mit einem mittleren Molekulargewicht $\overline{M}_n$ von 300-20'000 steht, enthaltend mindestens eine (wiederkehrende) Einheit der Formel III

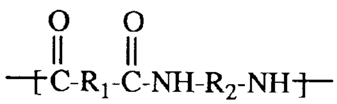 (III),

worin $R_1$ ein Rest der Formeln $-C_nH_{2n}-$,

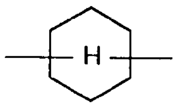 , 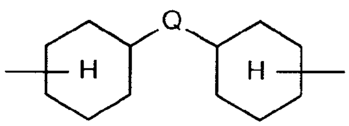 ,

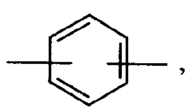 , 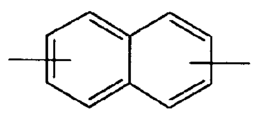

oder

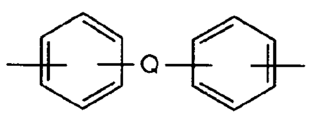

ist, und $R_2$ einen Rest der Formeln $-C_nH_{2n}-$,

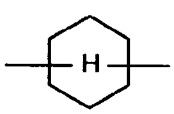 , 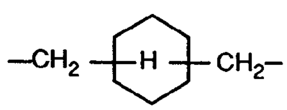 ,

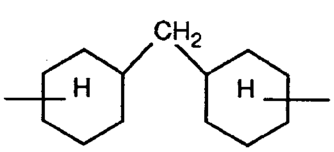 , 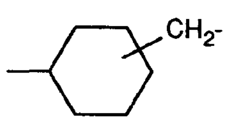 , 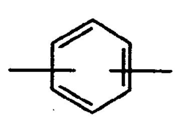 , 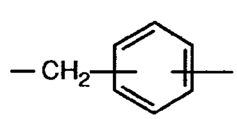 ,

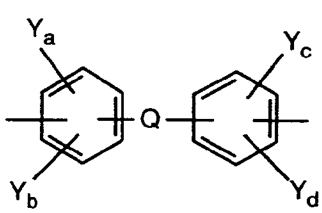 , 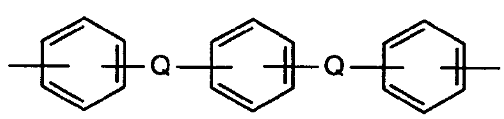

oder

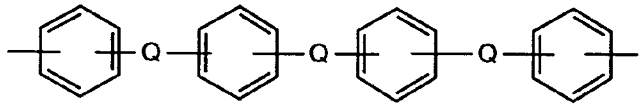

bedeutet, worin Q die direkte Bindung, $-CH_2-$, $-CH_2CH_2-$, $-CH(CH_3)-$, $-C(CH_3)_2-$, $-C(CF_3)-$, -O-, -S-, $-SO_2-$, oder -CO- ist, und n 2-12 ist, und $Y_a$, $Y_b$, $Y_c$ und $Y_d$ unabhängig voneinander Wasserstoff, Halogen oder $C_1$-$C_4$-Alkyl bedeuten, und PI für einen Polyimidblock mit einem mittleren Molekulargewicht $\overline{M}_n$ von 300-20'000 steht, enthaltend mindestens eine (wiederkehrende) Einheit der Formel IV

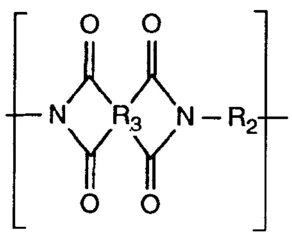

(IV),

worin $R_3$

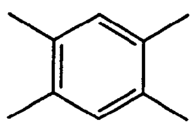 , 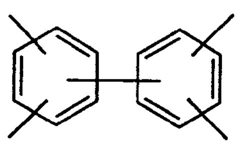 oder 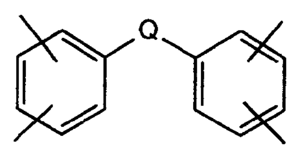

ist, und Q und $R_2$ die oben angegebene Bedeutung haben, mit der Massgabe, dass 25-100 Mol-% aller Brückenglieder $R_2$

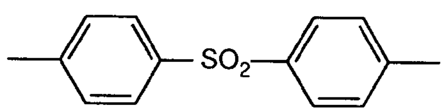

und/oder

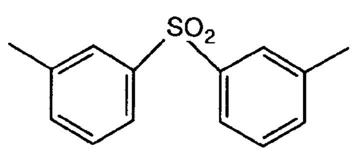

bedeuten, und der (cyclo-)aliphatische Anteil an Brückengliedern $R_2$ nicht mehr als 10 Mol-% beträgt.

Bevorzugt verwendete Blockcopolymere mit der wiederkehrenden Einheit der Formel II besitzen ein mittleres Molekulargewicht $\overline{M}_n$ von 4'000-40'000.

In bevorzugten Blockcopolymeren enthalten die Polyamidblöcke und/oder die Polyimidblöcke mehr als eine wiederkehrende Struktureinheit der Formel III bzw. der Formel IV. Dies ergibt für bevorzugte Polyamidblöke bzw. Polyimidblöcke ein mittleres Molekulargewicht von 500-20'000.

In den obenstehenden Formeln bedeutet $R_1$ z.B. Phenylen-1,3; Phenylen-1,4; Naphthylen-1,5; Naphthylen-1,8; Biphenylen-3,3', Biphenylen-4,4',

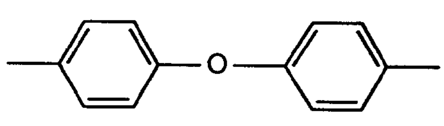 , 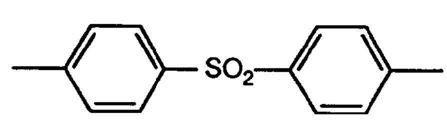

oder Butylen-1,4. Bevorzugt ist Phenylen-1,3.

$R_2$ in den Formeln III und/oder IV ist dadurch charakterisiert, dass in 25-100 Mol-% und insbesondere 50-100 Mol-% der im Copolymeren vorkommenden Bückenglieder $R_2$ Gruppen der Formeln

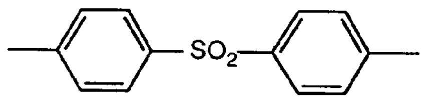

und/oder

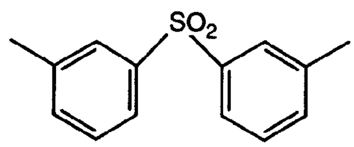

bedeutet. Dabei ist es nicht zwingend, dass sowohl Polyamid- als auch Polymidblöcke solche Bückenglieder enthalten.

Bedeuten $R_1$ oder $R_2$ je eine Gruppe $-C_nH_{2n}-$, so handelt es sich beispielsweise um Ethylen-1,2; Propylen-1,3; Tetramethylen-1,4; Pentamethylen-1,5; Hexamethylen-1,6; Heptamethylen-1,7; Octamethylen-1,8; Nonamethylen-1,9; Decamethylen-1,10; Dodecamethylen-1,12; Decamethylen-2,9; oder 2-Methylpentamethylen-1,5.

Sind $R_1$ oder $R_2$ eine Gruppe

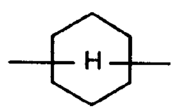 ,

so kann es sich um Cyclohexylen-1,2; Cyclohexylen-1,3 oder Cyclohexylen-1,4 handeln.

Weitere Beispiele für spezifische cycloaliphatische Gruppen $R_2$ sind

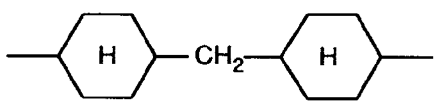 , 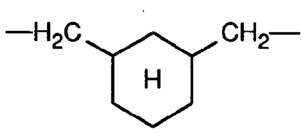 , 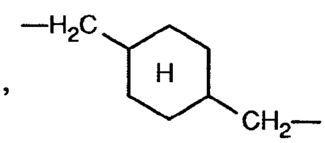 ,

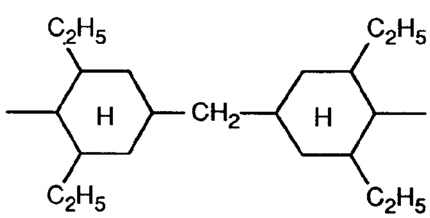 , 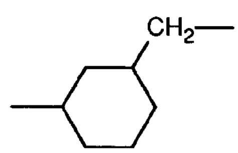 oder 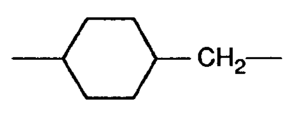 .

Beispiele für spezifische aromarische Gruppen $R_2$ sind Phenylen-1,2; Phenylen-1,3; Phenylen-1,4; Methylphenylen-2,4; 1,3,5-Trimethylphenylen-2,5; Xylylen-2,5; 4-Chlorphenylen- 1,3; 2,5-Dichlorphenylen-1,4; oder eine der folgenden Gruppen

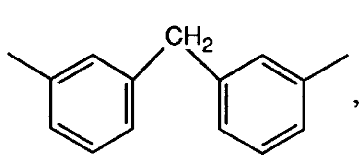 , 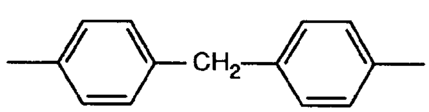 ,

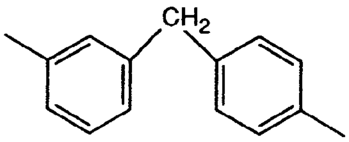 , 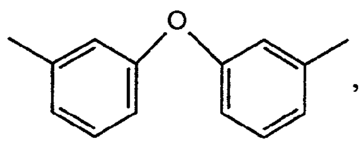 , 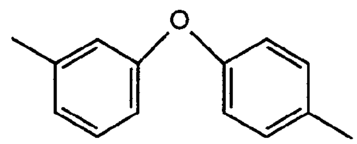 ,

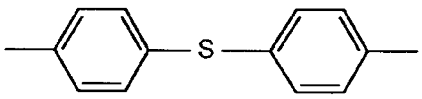 , 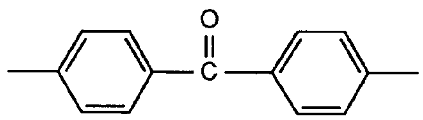 ,

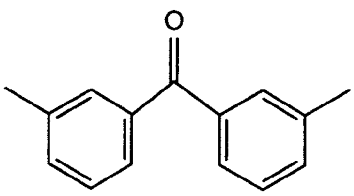 , 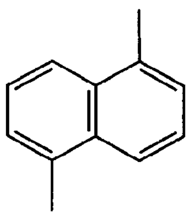 , 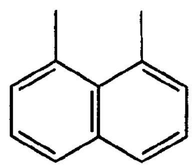 ,

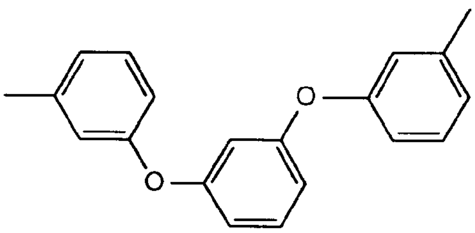 ,

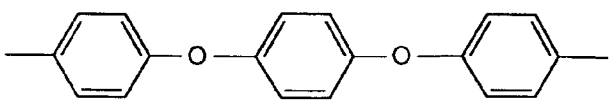 ,

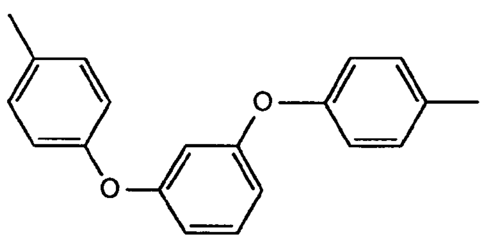 , 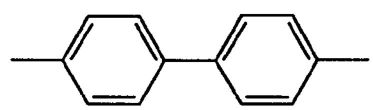 ,

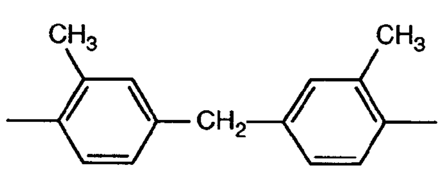 , 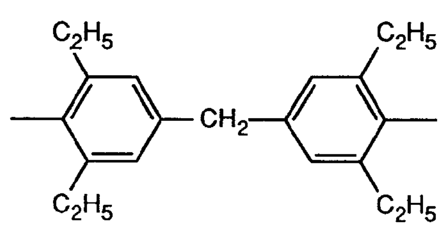 ,

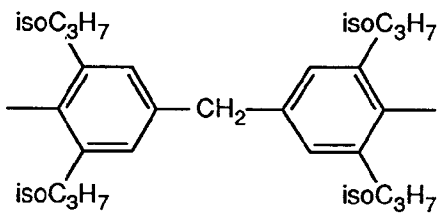 , 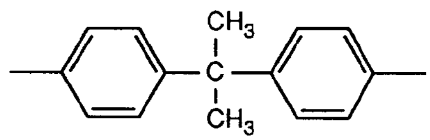 ,

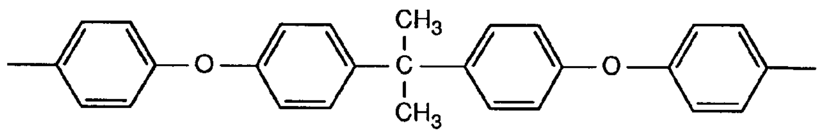 ,

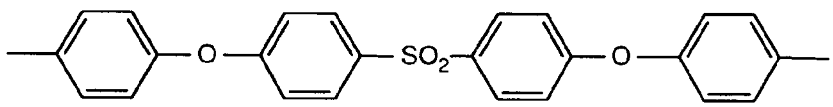 ,

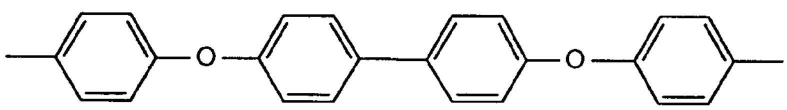 ,

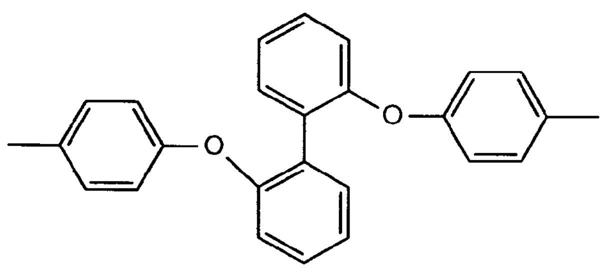

und insbesondere die Gruppen

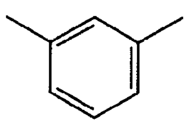 , 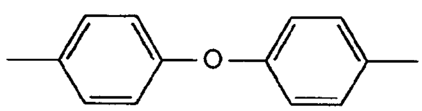 , 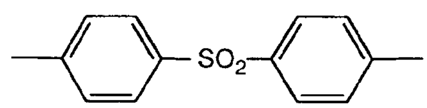

und

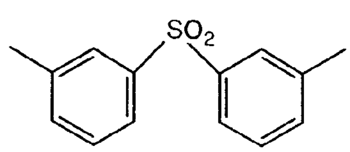

für $R_2$ in der Formel III, und die Gruppen

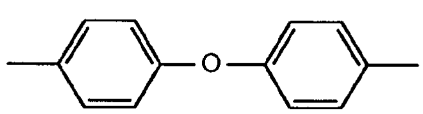 , 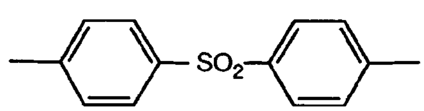

und

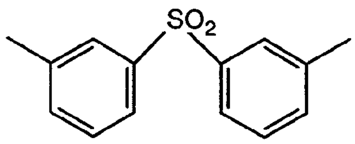

für $R_2$ in der Formel IV.

Enthalten die Brückenglieder $R_2$ einen zweiwertigen Rest Q, so handelt es sich beispielsweise um -$CH_2CH_2$- und -S-, und bevorzugt um -$CH_2$-,

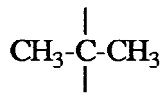
,

-O-, -$SO_2$- oder -C(O)-. Enthält ein Bückenglied $R_2$ mehrere Rest Q, so können diese gleich der verschieden sein.

Der vierwertige Rest $R_3$ leitet sich von einer Tetracarbonsäure ab, die fähig ist, ein Dianhydrid zu bilden. Es handelt sich dabei z.B. um Gruppen

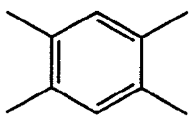
,
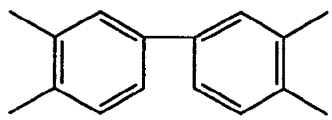
,
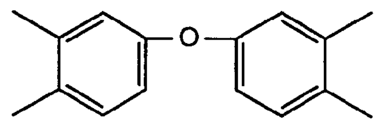
,

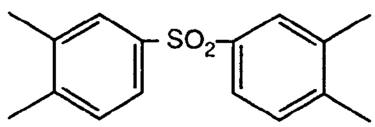
oder
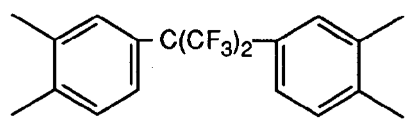
.

und insbesondere um

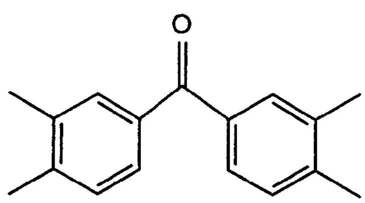
.

Beispiele für mögliche Kombinationen von Polyamid- und Polyimidblöcken zu PA-PI-Blockcopolymeren des Typs A sind in Tabelle I angegeben. Diese PA-PI-Blockcopolymeren können gemäss Beispiel 1 des EP-A-0 324 315 hergestellt werden.

Tabelle I: PA-PI-Blockcopolymere A

| PI - Block Tetracarbonsäure-dianhydrid | PI - Block Diamin | PA - Block Dicarbonsäure-dichlorid | PA - Block Diamin | Viskosität $\eta$ inh. [dl/g] PA-PAS | Viskosität $\eta$ inh. [dl/g] PA-PI | Löslichkeit in NMP [%] nach Trocken-temp. von 240°C |
|---|---|---|---|---|---|---|
| BTDA 0,0920 | mDDS/pDDS 0,0395/0,0395 | IPC 0,1625 | mDDS/pDDS 0,0855/0,0855 Mol | 0,57 | 0,63 | 42 |
| BTDA 0,0726 | pDDS 0,0622 | IPC 0,109 | pDDS 0,1209 Mol | 0,51 | 0,46 | 35 |
| BTDA 0,1440 | pDDS/DDE 0,1111/0,0123 | IPC 0,2507 | pDDS/DDE 0,2401/0,0267 Mol | 1,37 | 0,51 | 17 |
| BTDA 0,0937 | pDDS 0,0854 | IPC 0,1038 | mPDA 0,1109 Mol | 0,43 | 0,34 | 40 |
| BTDA 0,0978 | pDDS 0,0838 | IPC 0,0852 | pDDS 0,979 Mol | 0,60 | 0,73 | 35 |
| BTDA 0,822 | pDDS 0,0740 | IPC 0,0253 | pDDS 0,03312 Mol | 0,46 | 0,36 | 30 |
| BTDA 0,1192 | pDDS 0,0894 | IPC 0,3620 | pDDS 0,3876 Mol | 0,96 | 0,66 | 35 |
| BTDA 0,3445 | pDDS 0,2953 | IPC 0,5915 | mDDS 0,640 | 0,99 | 0,74 | 20 |
| BTDA/PMDA 0,1391/0,1398 | pDDS 0,2391 | IPC 0,4803 | pDDS 0,5189 Mol | 0,41 | 0,31 | 30 |

Tabelle I: (Fortsetzung)

| PI - Block | | PA - Block | | Viskosität $\eta$ inh. [dl/g] | | Löslichkeit in NMP [%] nach Trocken-temp. von 240°C |
|---|---|---|---|---|---|---|
| Tetracarbonsäure-dianhydrid | Diamin | Dicarbonsäure-dichlorid | Diamin | PA-PAS | PA-PI | |
| BTDA 0,1439 | pDDS 0,1241 | IPC 0,2530 | pDDS 0,2674 Mol | 0,43 | 0,36 | 35 |
| BTDA 0,2123 | pDDS 0,0592 }<br>mDDS 0,0591 }<br>pDDS 0,0591 } | IPC 0,326 | pDDS 0,1181 Mol }<br>mDDS 0,1181 Mol }<br>mBAPB 0,1181 Mol } | 0,86 | 0,69 | 35 |

BTDA: 3,3'-4,4'-Benzophenontetracarbonsäuredianhydrid
PMDA: Pyromellitsäuredianhydrid
pDDS: 4,4'-Diaminodiphenylsulfon
IPC: Isophthalsäuredichlorid
mDDS: 3,3'-Diaminodiphenylsulfon
DDE: 4,4'-Diaminodiphenylether
mBAPB: 1,3-Bis-(3-aminophenoxy)benzol
mPDA: m-Phenylendiamin
NMP: N-Methylpyrrolidon
Viskosität: 0,5 Gew.-% Polymeres in NMP bei 25°C (0,5 g Polymer auf 100 ml Lösung)
PA-PAS: Polyamid-Polyamidsäure

Weitere geeignete, in polaren aprotischen Lösungsmitteln lösliche PA-PI-Blockcopolymere vom Typ B mit wiederkehrenden Einheiten der Formel II und einem mittleren Molekulargewicht $\overline{M}_n$ von 1'000 bis 50'000 sind dadurch gekennzeichnet, dass diese ein Verhältnis von Amid- zu Imidgruppen von etwa 4:1 bis 1:4 aufweisen und dass diese Polymeren in den Polyimidblöcken einen Gehalt von mindestens 2 Mol.%, insbesondere von mindestens 5 Mol%, bezogen auf den Gehalt an allen Carbonsäureresten im Copolymeren, an Resten der Formel

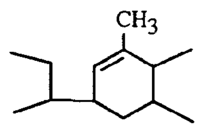,

die sich von der 5-(2,5-Diketotetrahydrofurfuryl)-3-methyl-3-cyclohexen-1,2-dicarbonsäure ableiten (nachfolgend DMCD Reste genannt), aufweisen.
Der Gehalt an DMCD Resten in den erfindungsgemäss verwendbaren PA-PI-Blockcopolymeren beträgt in der Regel 2 bis 80 Mol%, bezogen auf den Gehalt an allen Carbonsäureresten im Copolymeren.
Bevorzugt verwendete PA-PI-Blockcopolymere enthalten Kombinationen von Blöcken der Formeln Vb mit IVa und/oder IVc oder der Formeln IVb mit Va und/oder Vc

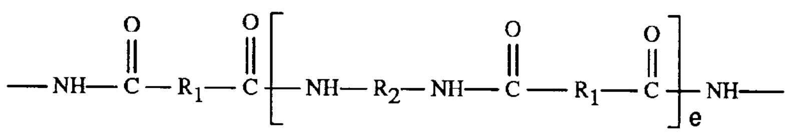 (IVa),

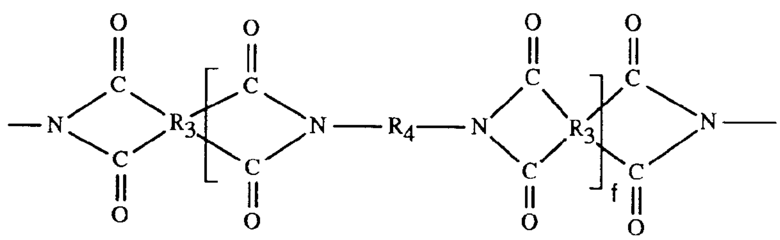 (IVb),

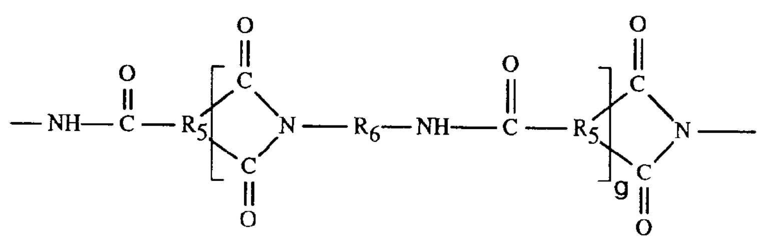 (IVc),

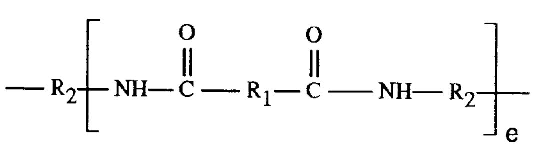 (Va),

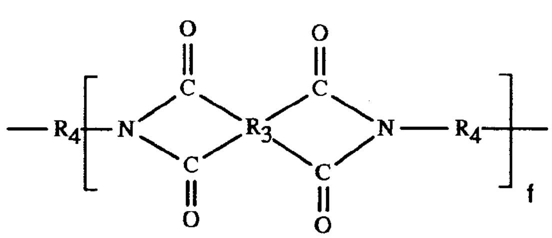 (Vb),

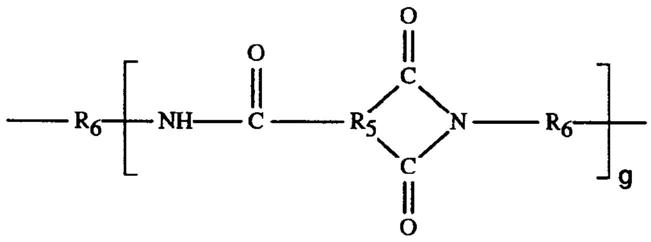 (Vc),

worin die Indizes e, f und g unabhängig voneinander ganze Zahlen von 1 bis 100 sind, $R_1$ und $R_2$ die gleiche Bedeutung wie in Formel III haben, $R_3$ ein Rest der Formeln

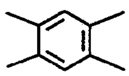, 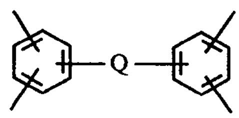, 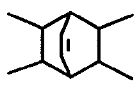, 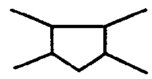 oder 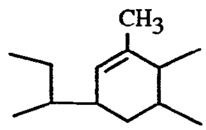 ist,

worin Q eine direkte Bindung darstellt oder $-CH_2-$, $-CH_2CH_2-$, $-CH(CH_3)-$, $-C(CH_3)_2-$, $-C(CF_3)_2-$, -O-, -S-, $-SO_2-$ oder -CO- bedeutet, $R_5$ ein Rest der Formel

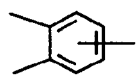

ist, und $R_4$ und $R_6$ unabhängig voneinander eine der für $R_2$ definierten Bedeutungen besitzen, mit der Massgabe, dass 25- 100 Mol % aller Reste $R_3$ die Formel

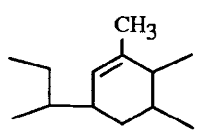 ;

aufweisen.

In den Formeln IVa und Va haben $R_1$ und $R_2$ die gleiche bevorzugte Bedeutungwie in Formel III.

Der vierwertige Rest $R_3$ leitet sich von einer Tetracarbonsäure ab, die in der Lage ist, ein Dianhydrid zu bilden.

Dabei handelt es sich bevorzugt um Reste der Formeln

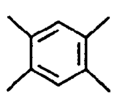, 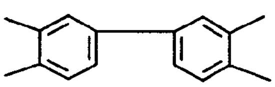, 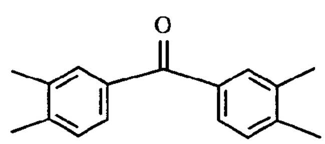,

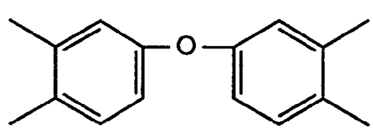, 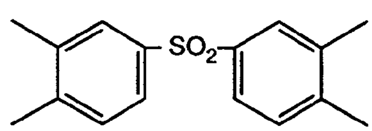

oder

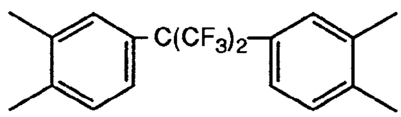

und ganz besonders um

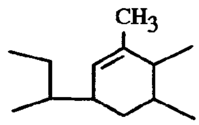.

Der Anteil der DMCD Reste in den Polyimidblöcken der erfindungsgemäss zu verwendenden Blockcopolymeren beträgt vorzugsweise 50 bis 100 Mol %, bezogen auf den Anteil der Tetracarbonsäurereste in diesen Blöcken.

$R_5$ ist vorzugsweise ein Rest der Formel

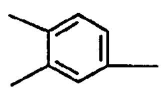.

Mögliche Kombinationen von Polyamid- mit Polyimidblöcken zu PA-PI-Blockcopolymeren des Typs B sind in Tabelle II angegeben.

Tabelle II: PA-PI-Blockcopolymere B

| PI - Block | | PA - Block | | $\eta_{inh}$ [dl/g] | | Löslichkeit in NMP [%] nach Trocken-temp. von 240°C |
|---|---|---|---|---|---|---|
| Tetracarbonsäure-dianhydrid (Mol) | Diamin (Mol) | Dicarbonsäure-dichlorid (Mol) | Diamin (Mol) | PA-PAS | PA-PI | |
| DMCD (0,2676) | DDE (0,2295) | IPC (0,4645) | mPDA (0,4980) | 1,01 | 0,67 | > 30 |
| DMCD (0,2500) | mDDS (0,1042) pDDS (0,1042) | IPC (0,3775) | mDDS (0,2084) pDDS (0,2084) | 0,46 | 0,40 | > 30 |
| DMCD (0,2404) | Diamingemisch (0,2004) | IPC (0,3657) | Diamingemisch (0,4037) | 0,59 | 0,52 | > 30* |
| DMCD (0,1052) BTDA (0,1052) | mXDA (0,091) pDDS (0,0917) | IPC (0,3657) | mPDA (0,3926) | 0,63 | 0,35 | > 30 |
| DMCD (0,1250) | DDE (0,1042) | IPC (0,1877) | DDE (0,2084) | 1,66 | 1,06 | >30 |

* Trockentemperatur 200°C

DMCD: 5-(2,5-Dioxotetrahydrofurfuryl)-3-methyl-3-cyclohexen-1,2-dicarbonsäureanhydrid
BTDA: 3,3',4,4'-Benzophenontetracarbonsäuredianhydrid
IPC: Isophthalsäuredichlorid
DDE: 4,4'-Diaminodiphenylether
pDDS: 4,4'-Diaminodiphenylsulfon
mDDS: 3,3'-Diaminodiphenylsulfon
mPDA: m-Phenylendiamin
mXDA: m-Xylylendiamin

Diamingemisch: technisches Produkt bestehend aus 4,4'-Diaminodiphenylmethan, 3-Ethyl-4,4'-Diaminodiphenylmethan, 3,3'-Diethyl-4,4'-Diaminodiphenylmethan (aus Aminzahl berechnetes durchschnittliches Molekulargewicht: 232)

Inhärente Viskosität: 0,5 Gew.-% Polymeres in NMP bei 25°C
PA-PAS: Polyamid-Polyamidsäure

Ebenfalls geeignete, in polaren aprotischen Lösungsmitteln lösliche PA-PI-Blockcopolymere vom Typ C mit einem durchschnittlichen Molekulargewicht $\overline{M}_n$ von 1'000 bis 50'000 enthalten die kombination von Blöcken der Formeln IVa mit Vb und/oder Vc oder der Formeln IVb mit Va und/oder Vc oder der Formeln IVc mit Va und/oder Vb, mit der anderen Massgabe, dass 10-100 Mol %, bevorzugt 25-100 Mol %, insbesondere 50-100 Mol %, aller Reste $R_2$, $R_4$ und $R_6$, bezogen auf die Gesamtmenge dieser Reste, die Formel

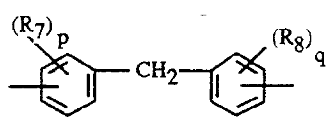

aufweisen, worin p 1 oder 2 und q Null, 1 oder 2 ist, $R_7$ und $R_8$ je ein $C_1$-$C_8$-Alkyl bedeuten oder worin je zwei zueinander ortho-ständige Reste $R_7$ und $R_8$ jeweils zusammen eine Alkylengruppe bilden.

Ein Alkylsubstituent $R_7$ oder $R_8$ in der oben angegebenen Formel kann verzweigt oder bevorzugt geradkettig sein. Bevorzugt wird geradkettiges $C_1$-$C_6$Alkyl. Beispiele dafür sind Methyl, Ethyl, n-Propyl, n-Butyl, n-Pentyl und n-Hexyl. Besonders bevorzugt werden Methyl und Ethyl.

Bilden die Reste $R_7$ oder $R_6$ zusammen eine Alkylenkette, so handelt es sich dabei vorzugsweise um Tri- oder insbesondere um Tetramethylen.

Das bevorzugte Verhältnis von Amidgruppen zu Imidgruppen in den zu verwendenden PA-PI-Blockcopolymeren beträgt 4:1 bis 1:4.

Die mittleren Molekulargewichte $\overline{M}_n$ in den Polyamidblöcken IVa und Va oder in den Polyimidblöcken IVb und Vb oder in den Polyamidimidblöcken IVc und Vc der PA-PI-Blockcopolymeren C betragen im allgemeinen 300 bis 20'000, vorzugsweise 500 bis 10'000.

Neben den oben erwähnten kombinationen von zwei Blöcken können die erfindungsgemäss zu verwendenden PA-PI Blockcopolymeren C auch Dreiblockkombinationen der Formeln IVa, IVb und Vc oder der Formeln IVa, IVc und Vb oder der Formeln IVb, IVc und Va enthalten.

Bevorzugt verwendet man PA-PI Blockcopolymere C, die im wesentlichen aus Polyamidblöcken IVa und Polyimidblöcken IVb oder aus Polyamidblöcken Va und Polyimidblöcken IVb bestehen.

Beispiele für mögliche Kombinationen von Polyamid- mit Polyimidblöcken zu PA-PI-Blockcopolymeren C sind in folgender Tabelle M angegeben.

In der Tabelle III werden die folgenden Abkürzungen verwendet:

| | |
|---|---|
| $\eta_{inh}$: | Inhärente Viscosität gemessen an einer 0,5 gew.%igen Lösung des Polymeren bei 25°C (in NMP), |
| BTDA: | 3,3',4,4'-Benzophenontetracarbonsäuredianhydrid, |
| BPDA: | 3,3',4,4'-Biphenyltetracarbonsäure dianhydrid, |
| IPC: | Isophthalsäuredichlorid, |
| TMAC: | Trimellitsäureanhydridchlorid, |
| BADM: | Bis-(3,5-diethyl-4-aminophenyl)-methan, |
| BEMA: | Bis-(3-ethyl-5-methyl-4-aminophenyl)-methan, |
| BIDM: | Bis-(3,5-diisopropyl-4-aminophenyl)-methan, |
| mDDS: | 3,3'-Diaminodiphenylsulfon, |
| pDDS: | 4,4'-Diaminodiphenylsulfon, |
| Diamingemisch: | Technisches Produkt bestehend aus 4,4'-Diaminodiphenylmethan, 3-Ethyl-4,4'-diaminodiphenylmethan und aus 3,3'-Diethyl-4,4'-diaminodiphenylmethan, |
| PA-PAS: | Polyamid-Polyamidsäure. |

Tabelle III: PA-PI-Blockcopolymere C

| PI - Block: Tetracarbonsäure-dianhydrid (Mol) | PI - Block: Diamin (Mol) | PA - Block: Dicarbonsäure-dichlorid (Mol) | PA - Block: Diamin (Mol) | $\eta_{inh}$ [dl/g] PA-PAS | $\eta_{inh}$ [dl/g] PA-PI | Löslichkeit in NMP [%] |
|---|---|---|---|---|---|---|
| BTDA 0,2970 | Diamingemisch 0,2447 | IPC 0,4455 | Diamingemisch 0,4957 | 0,45 | 0,49 | > 25 |
| BTDA 0,2815 | Diamingemisch 0,2470 | IPC 0,2177 | Diamingemisch 0,2470 | 0,35 | 0,41 | > 25 |
| BTDA 0,2002 | Diamingemisch 0,3566 | IPC 0,0643 | Diamingemisch 0,1585 | 0,33 | 0,49 | > 25 |
| BTDA 0,1551 | pDDS 0,1292 | IPC 0,2326 | Diamingemisch 0,1292<br>pDDS 0,1292 | 0,33 | 0,28 | > 25 |
| BTDA 0,1500 | mDDS 0,0417<br>pDDS 0,0417<br>Diamingemisch 0,0417 | IPC 0,2275 | Diamingemisch 0,0833<br>mDDS 0,0833<br>pDDS 0,0833 | 0,52 | 0,52 | > 25 |
| BTDA 0,1500 | mDDS 0,0417<br>pDDS 0,0417<br>BADM 0,0417 | IPC 0,2275 | BADM 0,0833<br>mDDS 0,0833<br>pDDS 0,0833 | 0,38 | 0,38 | > 25 |
| BTDA 0,1500 | mDDS 0,0417<br>pDDS 0,0417<br>BIDM 0,0417 | IPC 0,2275 | BIDM 0,0833<br>mDDS 0,0833<br>pDDS 0,0833 | 0,36 | 0,36 | > 25 |
| BPDA 0,1500 | Diamingemisch 0,1250 | IPC 0,2275 | Diamingemisch 0,2500 | 0,41 | 0,54 | > 20 |
| BPDA 0,1500 | pDDS 0,0625<br>Diamingemisch 0,0625 | IPC 0,2275 | pDDS 0,2500 | 0,85 | 0,67 | > 25 |
| BTDA 0,1250 | BADM 0,0938 | IPC 0,0938 | Diamingemisch 0,1250 | 0,56 | 0,54 | > 25 |
| BTDA 0,2500 | mDDS 0,0695<br>BEMA 0,0695<br>pDDS 0,0695 | IPC 0,3790 | mDDS 0,1389<br>BEMA 0,1389<br>pDDS 0,1389 | 0,48 | 0,40 | > 25 |
| BTDA 0,2500 | BEMA 0,1875 | IPC 0,1879 | BEMA 0,2500 | 0,49 | 0,51 | > 25 |
| TMAC 0,2500 | Diamingemisch 0,2920 | IPC 0,1690 | Diamingemisch 0,1250 | 0,67 | 0,59 | > 25 |
| BPDA 0,2500 | Diamingemisch 0,1875 | TMAC 0,1895 | Diamingemisch 0,2500 | 1,45 | 0,80 | > 25 |

Weitere geeignete, in polaren aprotischen Lösungsmitteln lösliche PA-PI-Blockcopolymere vom Typ D mit einem durchschnittlichen Molekulargewicht $\overline{M}_n$ von 1'000 bis 50'000, vorzugsweise 5'000 bis 40'000, enthalten die Kombination von Blöcken der Formeln IVa mit Vb und/oder Vc oder der Formeln IVb mit Va und/oder Vc oder der Formeln IVc mit Va und/oder Vb, mit der anderen Massgabe, dass 25-100 Mol % aller Reste $R_2$, $R_4$ und $R_6$, bezogen auf die Gesamtmenge dieser Reste, die Formel

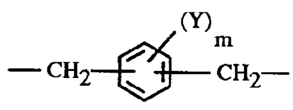

und/oder

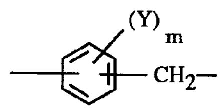

aufweisen, worin Y ein $C_1$-$C_8$-Alkyl oder Halogen bedeutet und m für eine Zahl von 0 bis 4 steht.

Der Alkylsubstituent Y in den oben angegebenen Formeln kann verzweigt oder bevorzugt geradkettig sein. Bevorzugt wird geradkettiges $C_1$-$C_6$Alkyl. Beispiele für sind Methyl, Ethyl, n-Propyl, n-Butyl, n-Pentyl und n-Hexyl. Besonders bevorzugt wird Methyl.

Y als Halogen ist vorzugsweise Chlor oder Brom, und m steht vorzugsweise für Null oder die Zahl 1.

Das Verhältnis von Polyamidblöcken zu Polyimidblöcken oder zu Polyamidimidblöcken in den erfindungsgemäss zu verwendenden Blockcopolymeren D wird im allgemeinen durch die gewünschte Löslichkeit dieser Copolymeren in polaren, aprotischen Lösungsmitteln bestimmt. Die jeweiligen Anteile dieser Blöcke und der Gehalt an Xylylendiamineinheiten und/oder an Aminobenzylamineinheiten werden so gewählt, dass das Blockcopolymere in polaren, aprotischen Lösungsmitteln löslich ist.

Das bevorzugte Verhältnis von Amidgruppen zu Imidgruppen in den zu verwendenden PA-PI-Blockcopolymeren D beträgt 4:1 bis 1:4.

Die mittleren Molekulargewichte $\overline{M}_n$ der Polyamidblöcke IVa oder Va oder der Polyimidblöcke IVb oder Vb oder der Polyamidimidblöcke IVc oder Vc in den PA-PI-Blockcopolymeren D betragen im allgemeinen 300 bis 20'000, vorzugsweise 500 bis 10'000.

Neben den oben erwähnten Kombinationen von zwei Blöcken können die erfindungsgemäss zu verwendenden PA-PI-Blockcopolymeren D auch Dreiblockkombinationen der Formeln IVa, IVb und Vc oder IVa, IVc, IVc und Vb oder IVb, IVc und Va enthalten.

Besonders bevorzugt sind PA-PI-Blockcopolymere D die im wesentlichen aus den wiederkehrenden Struktureinheiten der Formeln IVa und IVb oder IVb und Va bestehen.

Ganz besonders bevorzugte PA-PI-Blockcopolymere dieses Typs enthalten die Xylylendiamineinheiten oder die Aminobenzylamineinheiten oder eine Kombination von Xylylendiamineinheiten und Aminobenzylamineinheiten nur in den Polyimidblöcken IXb oder Xb.

Beispiele für mögliche Kombinationen von Polyamid- mit Polyimidblöcken zu PA-PI-Blockcopolymeren D sind in folgender Tabelle IV angegeben, in der folgende Abkürzungen verwendet werden:

BTDA: 3,3',4,4'-Benzophenontetracarbonsäuredianhydrid,
BPDA: 3,3',4,4'-Biphenyltetracarbonsäuredianhydrid,
IPC: Isophthalsäuredichlorid,
TMAC: Trimellitsäureanhydridchlorid,
mXDA: m-Xylylendiamin,
pXDA: p-Xylylendiamin,
ABA: Aminobenzylamin (Gemisch von m- und p-Isomeren),
mPDA: m-Phenylendiamin
mDDS: 3,3'-Diaminodiphenylsulfon,
pDDS: 4,4'-Diaminodiphenylsulfon,
PA-PAS: Polyamid-Polyamidsäure.

Tabelle IV: PA-PI-Blockcopolymere D

| PI - Block: Tetracarbonsäure-dianhydrid (Mol) | PI - Block: Diamin (Mol) | PA - Block: Dicarbonsäure-dichlorid (Mol) | PA - Block: Diamin (Mol) | $\eta_{inh}$ [dl/g] PA-PAS | $\eta_{inh}$ [dl/g] PA-PI | Löslichkeit in NMP (%) nach Trocknung bei 200°C |
|---|---|---|---|---|---|---|
| BPDA 0,1500 | mXDA 0,0625, pDDS 0,0625 | IPC 0,2275 | pDDS 0,2500 | 0,64 | 0,74 | > 25 |
| BTDA 0,1500 | mXDA 0,0625, pDDS 0,0625 | IPC 0,2275 | pDDS 0,2500 | 0,59 | 0,67 | > 25 |
| BTDA 0,1500 | mXDA 0,0625, mDDS 0,0625 | IPC 0,2275 | mDDS 0,2500 | 0,33 | 0,59 | > 25 |
| BTDA 0,1500 | mXDA 0,0625, mDDS 0,0313, pDDS 0,0313 | IPC 0,2275 | mDDS 0,1250, pDDS 0,1250 | 0,48 | 0,54 | > 25 |
| BTDA 0,1500 | mXDA 0,0416, mDDS 0,0416, pDDS 0,0416 | IPC 0,2275 | mDDS 0,0833, pDDS 0,0833, mPDA 0,0833 | 0,40 | 0,40 | > 25 |
| BTDA 0,0919 | mXDA 0,0395, pDDS 0,0397 | IPC 0,1608 | mXDA 0,0858, mPDA 0,0854 | 0,40 | 0,31 | > 25 |
| TMAC 0,1066 | mXDA 0,1247 | IPC 0,2352 | mPDA 0,2136 | 0,23 | 0,25 | > 25 |
| BTDA 0,1250 | pXDA 0,0521, pDDS 0,0521 | IPC 0,1900 | pDDS 0,2084 | 0,45 | 0,43 | > 25 |
| BTDA 0,1250 | ABA 0,0521, pDDS 0,0521 | IPC 0,1900 | pDDS 0,2084 | 0,45 | 0,35 | > 25 |
| BTDA 0,1250 | pDDS 0,1042 | IPC 0,1900 | ABA 0,1042, pDDS 0,1042 | 0,36 | 0,28 | > 25 |
| BTDA 0,1250 | pDDS 0,0521, ABA 0,0521 | IPC 0,1900 | ABA 0,1042, pDDS 0,1042 | 0,35 | 0,31 | > 25 |
| BTDA 0,1250<br>TMAC 0,1250 | pDDS 0,1460, mXDA 0,1460 | IPC 0,3610 | pDDS 0,3210 | 0,52 | 0,46 | > 25 |

Die Herstellung der erfindungsgemäss zu verwendenden Blockcopolymeren erfolgt in an sich bekannter Weise und kann beispielsweise nach einer der in der DE-A-2,342,464 beschriebenen Arbeitsweise durch Umsetzung vorgeformter Polyamid- und Polyamidsäure- und/oder Polyamidamidsäureblöcke und anschliessende Cyclisierung der Polyamid-Polyamidsäuren zum Polyamid-Polyimid-Blockcopolymeren erfolgen.

Gemäss einer weiteren Herstellungsmethode können Polyamidsäureblöcke mit geeigneten Endgruppen, vorzugsweise Anhydridgruppen, mit Diaminen oder Dicarbonsäurederivaten, beispielsweise Dicarbonsäurechloriden und/oder Tricarbonsäureanhydrid-chloriden, umgesetzt und die so erhaltenen Polyamidsäuren cyclisiert werden.

Die erfindungsgemäss zu verwendenden Blockcopolymeren können auch dadurch hergestellt werden, indem man in an sich bekannter Weise zuerst einen Polyamid- und/oder Polyamidamidsäureblock aufbaut und diesen anschliessend mit einem geeigneten Tetracarbonsäurederivat und einem Diamin bzw. mit einem geeigneten Dicarbonsäuredichlorid und einem Diamin zu einem Polyamid-Polyamidamidsäure-Blockcopolymer umsetzt und dieses anschliessend cyclisiert. Ein solches Verfahren ist beispielsweise in der DE-A-2,342,454 beschrieben.

Beispielsweise kann ein PA-PI-Blockcopolymer vom Typ A hergestellt werden, indem man Polyamide der Formel VII

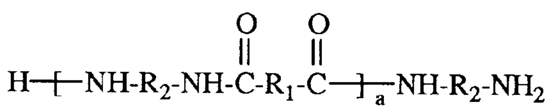

(VII)

mit Polyamidsäuredianhydriden der Formel VIII

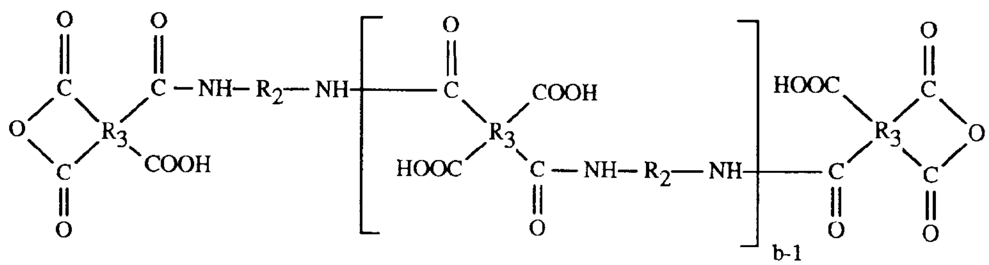

(VIII)

oder Polyamide der Formel IX

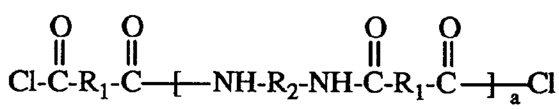

(IX)

mit Polyamidsäuren der Formel X

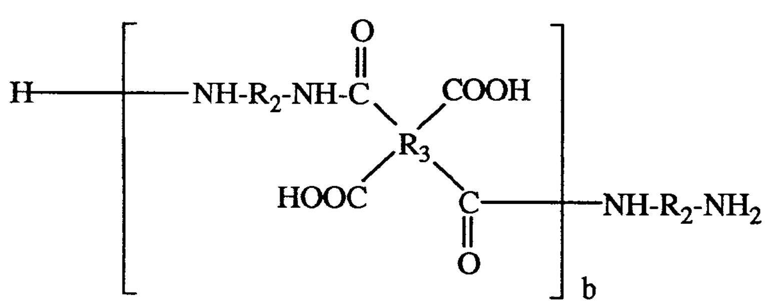

(X)

umsetzt, oder indem man Polyamidsäuren der Formel VIII oder X mit Dicarbonsäuredichloriden der Formel XI

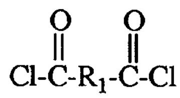 (XI)

und Diaminen der Formel XII

$H_2N-R_2-NH_2$ (XII)

umsetzt und die so erhaltenen Polyamid-Polyamidsäure-Copolymeren anschliessend cyclisiert, und wobei in den Formeln VII bis XII $R_1$, $R_2$ und $R_3$ die gleiche Bedeutung wie in Formeln III und IV haben und a und b unabhängig voneinander eine ganze Zahl von mindestens 2 bedeuten.

Die Verbindungen der Formeln VII bis XII sind bekannt. Die Herstellung der Polyamidsäuren der Formeln VIII und X ist ebenfalls in der DE-A 2,342,464 beschrieben und erfolgt z.B. durch die Umsetzung von Tetracarbonsäuredianhydriden der Formel XIII

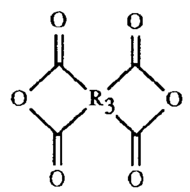 (XIII),

worin $R_3$ die angegebene Bedeutung hat, mit einem Unterschuss bzw. Ueberschuss eines Diamins der Formel XII. Dabei ist es trivial und dem Fachmann geläufig, wie er durch geeignete Reaktionsbedingung, z.B. durch geeignete Wahl der Molverhältnisse der Reaktionspartner, die mittleren oben definierten Molekulargewichte (und damit a und b) der einzelnen Blöcke einstellen kann. Die Polykondensation der Di- oder Tetracarbonsäurederivate der Formeln VIII, IX bzw. XI mit den Diaminen der Formeln VII bzw. XII kann auf an sich bekannte Weise vorgenommen werden, vorzugsweise in einem wasserfreien organischen Lösungsmittel und unter Feuchtigkeitsausschluss, z.B. unter Stickstoff, bei Temperaturen zwischen etwa -20°C und +50°C, insbesondere etwa -15°C bis +10°C. Geeignete organische Lösungsmittel sind polare aprotische Lösungsmittel, wie N,N-Dimethylacetamid, N,N-Diethylacetamid, N,N-Dimethylformamid, N,N-Dimethylmethoxyacetamid, N-Methyl-2-pyrrolidon, N-Acetyl-2-pyrrolidon, N-Methyl-ε-caprolactam, N,N,N',N'-Tetramethylharnstoff, Tetrahydrothiophendioxid (Sulfolan), γ-Butyrolacton und Dimethylsulfoxid.

Die Reaktion kann auch in Gemischen solcher Lösungsmittel durchgeführt werden. Andererseits ist es auch möglich, diese bevorzugten Lösungsmittelsysteme mit anderen organischen aprotischen Lösungsmitteln, wie aromatischen, cycloaliphatischen oder aliphatischen Kohlenwasserstoffen, beispielsweise Toluol, Xylolen, Cyclohexan,Pentan, Hexan, Methylenchlorid, Tetrahydrofuran und Cyclohexanon, zu verdünnen.

Die Polyamidblöcke können auch mittels Grenzflächen-Polykondensation hergestellt werden.

Die in DE-A-2 366 273, EP-A-0 048 219, EP-A-0 048 221 und EP-A-0 134 752 beschriebenen PA-PI-Blockcopolymeren und die PA-PI-Blockcopolymeren der Typen B, C und D können unter Verwendung der entsprechenden Ausgangsverbindungen nach den gleichen oben angegebenen Verfahren hergestellt werden.

Eine weitere Herstellungsmethode für die Blockcopolymeren vom Typ B, C und D umfasst die Umsetzung von Polyamidsäuren der Formel VIII und/oder XIV

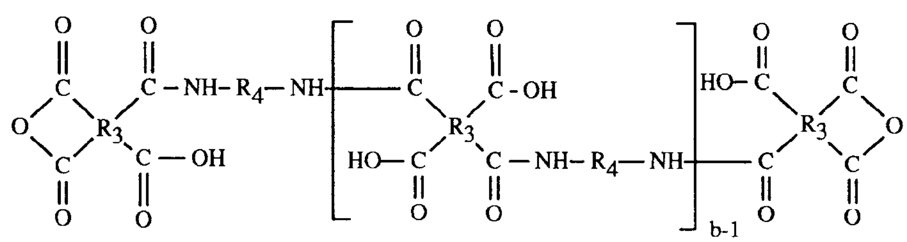 (VIII)

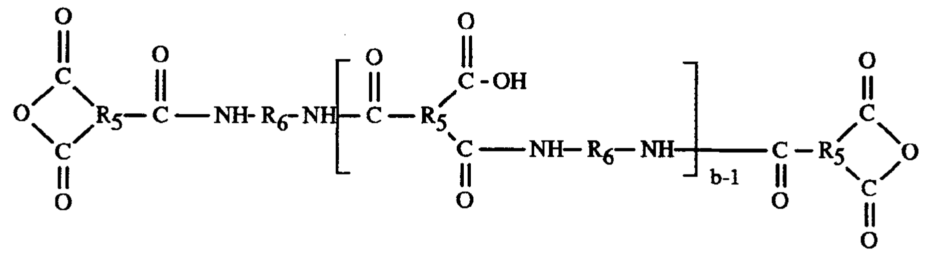 (XIV)

mit Diaminen der Formel XII

$H_2N\text{-}R_2\text{-}NH_2$ (XII)

und mit Dicarbonsäurechloriden der Formel XI

$Cl\text{-}OC\text{-}R_1\text{-}CO\text{-}Cl$ (XI)

und die anschliessende Cyclisierung der so erhaltenen Polyamid-Polyamidsäure Blockcopolymeren. In den Formeln VIII, XIV, XII und XI haben die Symbole $R_1$, $R_2$, $R_3$, $R_4$, $R_5$ und $R_6$ die oben angegebene Bedeutung und b steht für eine ganze Zahl von mindestens 2.

Die Herstellung der Polyamidsäure der Formel XIV ist ebenfalls an sich bekannt und erfolgt beispielsweise durch die Umsetzung von Tricarbonsäureanhydriden der Formel XV oder einem entsprechenden Tricarbonsäureanhydridchlorid

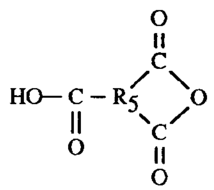 (XV),

worin $R_5$ die oben angegebene Bedeutung hat, mit einem Unterschuss eines Diamins der Formel XII.

Die Ausgangsprodukte der Formel XV sind an sich bekannt und teilweise im Handel erhältlich.

Die Herstellung von DMCD-Dianhydrid

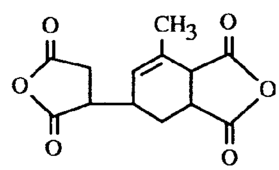

ist aus der EP-A-9,645 bekannt und kann durch Umsetzung von 3-Methyl-4-cyclohexen-1,2-dicarbonsäureanhydrid mit Maleinsäureanhydrid erfolgen.

Durch Wahl der geeigneten Reaktionsbedingungen, wie z.B. durch geeignete Wahl der Molverhältnisse der Reaktionspartner, lassen sich die gewünschten mittleren Molekulargewichte der einzelnen Blöcke einstellen. Diese Auswahl ist dem Fachmann an sich bekannt.

Die Polykondensation der Di-, Tri- oder Tetracarbonsäurederivate der Formeln VIII, XIV, XI und XV mit den Diaminen der Formel XII kann auf an sich bekannte Weise vorgenommen werden, vorzugsweise in einem wasserfreien organischen Lösungsmittel und unter Feuchtigkeitsausschluss, z.B. unter Stickstoff bei Temperaturen zwischen-20°C und +50°C, insbesondere etwa -15°C bis +10°C.

Die Beschichtung der Metallfolien mit den PA-PI-Blockcopolymer-Lösungen kann sowohl von Hand als auch mit Beschichtungsmaschinen vorgenommen werden. Es können auch vertikale Beschichtungsmaschinen eingesetzt werden. Insbesondere bei der maschinellen Beschichtung ist es lediglich wichtig, dass eine klebfreie Beschichtung auf der Metallfolie erhalten wird, so dass dieser Schichtstoff sich gewünschtenfalls aufrollen lässt.

Nach der Applikation erfolgt die Trocknung der Beschichtung bei erhöhter Temperatur, beispielsweise bei 180°C bit 280°C, im Verlauf von 30 bis 90 Minuten. Trocknungs-Zeit und -Temperatur sind vom verwendeten PA-PI-Blockcopolymeren, dem eingesetzten Lösungsmittel und der gewünschten Schichtdicke abhängig. Die Beschichtungen zeichnen sich durch eine gute Haftung auf Metallen und durch eine sehr gute Oberflächenbeschaffenheit aus.

Besonders lösungsmittelstabile Beschichtungen werden erhalten, indem die aus DE-A-2 342 464, DE-A-2 342 454, DE-A-2 366 273, EP-A-0 048 219 oder EP-A-0 048 221 bekannten Polyamid-Polyamidsäurecopolymere auf der Metallfolie im Verlauf oder nach der Trocknung zum entsprechenden Polyamid-Polyimid-Blockcopolymeren cyclisiert werden. Eine weitere vorteilhafte Methode für lösungsmittelstabile Beschichtungen ist die Verwendung der in EP-A-0 381 619, EP-A-0 381 620 und EP-A-0 381 620 beschriebenen Polyamid-Polyimid-Blockcopolymeren, die in einem der Trocknung nachfolgenden Reaktionsschritt thermisch vernetzt werden können. Diese Temperaturbehandlung kann beispielsweise bei 220-350°C erfolgen und wird vorzugsweise direkt bei der Herstellung der erfindungsgemässen Mehrschichtlaminate direkt durchgeführt.

Gewünschtenfalls kann auch ein Gemisch von verschiedenen PA-PI-Blockcopolymeren eingesetzt werden.

Weiterhin können den in Lösung vorliegenden Polyamid-Polyamidsäure-Blockcopolymeren oder Polyamid-Polyimid-Blockcopolymeren übliche Zusatzstoffe, wie Stabilisatoren und Cyclisierungskatalysatoren und vorzugsweise sogenannte Verlaufsmittel, beispielsweise BYK® S 706 der Firma BYK-Chemie, Wesel, zugegeben werden.

Die Herstellung der erfindungsgemässen Mehrschichtlaminate aus mit PA-PI-Blockcopolymeren beschichteten Metallfolien oder mit Polyamid-Polyamidsäure-Blockcopolymeren beschichteten Metallfolien, die einem zusätzlichen Cyclisierungsschritt unterworfen werden, erfolgt durch Verpressen mit einer ebenso hergestellten beschichteten Metallfolie oder mit einer unbeschichteten Metallfolie unter Druck, beispielsweise zwischen 10 bis 200 kg/cm$^2$, bei einer Temperatur zwischen 180 bis 350°C. Auf diese Weise lassen sich auch mehr als zwei beschichtete Metallfolien oder zwei beschichtete Metallfolien mit einer unbeschichteten Metallfolie miteinander verpressen, wenn im Mehrschichtlaminat Metall- und PA-PI-Blockcopolymerschichten alternierend angeordnet sind.

Gegenstand vorliegender Erfindung ist somit auch ein Verfahren zur Herstellung von Mehrschichtlaminaten, dadurch gekennzeichnet, dass man eine mit einem PA-PI-Blockcopolymer beschichtete Metallfolie mit einer unbeschichteten Metallfolie oder mit einer oder mehreren mit einem PA-PI-Blockcopolymer beschichteten Metallfolien unter Druck zwischen 180 bis 350°C verpresst.

Vorzugsweise werden dabei zwei einseitig mit einem PA-PI-Blockcopolymer beschichtete Metallfolien mit der beschichteten Seite zueinander unter Druck zwischen 180 und 350°C verpresst.

Die auf diese Weise beschichteten Metallfolien können direkt zur Herstellung von elektronischen Schaltungen verwendet werden, indem man die auf den Metallseiten mit einem Photolack versehene Folie belichtet, beispielsweise durch eine Photomaske,und die belichtete Metallfolie in bekannter Weise entwickelt. Dabei werden flexible, gedruckte Schaltungen erhalten.

Beispiele:

a. Herstellung des PA-PI-Blockcopolymeren A

Polyamidsäureblock: In einem Doppelmantelreaktionsgefäss mit Schutzgasanschluss, Innenthermometer, Tropfrichter und Rührer werden unter Stickstoff 70,60 g (0,2191Mol) 3,3′,4,4′-Benzophenontetracarbonsäuredianhydrid und 222 g N-Methylpyrrolidon (NMP) eingewogen. Das Reakltionsgefäss wird dreimal evakuiert und mit Stickstoff begast. Nach dem Abkühlen auf -10°C ergibt sich eine Suspension. Ueber dem Tropfrichter wird bei -15°C im Verlauf von 1 Stunde und 30 Minuten eine Lösung von 38,55 g (0,1662 Mol) eines technischen Gemisches aus 4,4′-Diaminodiphenylmethan, 3-Ethyl-4,4′-diaminodiphenylmethan und 3,3′-Diethyl-4,4′-diaminodiphenylmethan (aus der Aminzahl bestimmtes Molekulargewicht: 232), wobei der Anteil an substituiertem Diaminodiphenylmethan grösser als 80 Gew.-% ist, in 190 g NMP zugegeben. Danach lässt man die Reaktionsmischung auf Raumtemperatur kommen und rührt 3 Stunden weiter.

Polyamid-Polyamidsäure-Blockcopolymeres: Die klare Reaktionsmischung wird erneut abgekühlt (-10°C). Ueber den Tropfrichter werden dann 50,90 g (0,1643 Mol) des oben beschriebenen Diamingemisches in 198 g NMP im Verlauf von 1 Stunde zugetropft. Im folgenden werden 33,36 g (0,1643 Mol) Isophthalsäuredichlorid portionsweise zugegeben, so dass die Innentemperatur 0°C nicht übersteigt. Man benötigt etwa 120 Minuten, wobei die Lösung in zunehmendem Masse viskos wird. Schliesslich wird die Polymerlösung innerhalb von 30 Minuten auf Raumtemperatur gebracht. Es folgt dann die Zugabe von 1, 15 g (0,0057 Mol) Isophthalsäuredichlorid in drei etwa gleichen Teilen innerhalb von 1 Stunde. Zur Vervollständigung der Polykondensation wird 5 Stunden nachgerührt. Nach Stehen über Nacht gibt man über einen Tropfrichter im Verlauf von 45 Minuten 24,82 g (0,3442 Mol) Butylenoxid bei einer Temperatur von 18°C zu. Man erhält auf diese Weise eine Lösung eines Polyamid-Polyamidsäure-Blockcopolymeren mit einer inhärenten Viskosität von 0,70 dl/g (0,5 Gew.-% an Feststoff in NMP/25°C).

Cyclisierung: Die vorliegende Polyamid-Polyamidsäure Blockcopolymeren-Lösung wird nun der chemischen Cyclisierung zum PA-PI-Blockcopolymeren unterzogen. Dazu erfolgt über einen Tropfrichter die Zugabe eines Gemisches aus 121,23 g (1,1980 Mol) Triethylamin und 126,25 g (1,2367 Mol) Acetanhydrid zu der oben beschriebenen Lösung innerhalb von 20 Minuten bei 25°C. Man lässt nun 24 Stunden bei Raumtemperatur rühren.

Die so hergestellte Lösung des PA-PI-Blockcopolymeren wird mit der gleichen Menge NMP verdünnt, in der 10fachen Menge Isopropanol ausgefällt und im Vakuumtrockenschrank bis zu einer Temperatur von 180°C getrocknet. Die inhärente Viskosität (0,5 %, NMP, 25°C) des Polymeren beträgt 0,61 dl/g.

Das getrocknete PA-PI-Blockcopolymere wird in N-Methylpyrrolidon gelöst, so dass eine 20 Gew.-%ige Lösung resultiert. Diese Lösung wird für die nachfolgend beschriebene Beschichtung verwendet.

b. Herstellung eines Mehrschichtlaminates mit dem PA-PI-Blockcopolymeren A

Auf eine 35 µm starke Kupferfolie aus Elektrolytkupfer wird ein Nassfilm von 150 µm der PA-PI-Blockcopolymer-Lösung A auf der Behandlungsseite aufgetragen. Die Beschichtung wird 30 Minuten im Abstand von 30 cm unter einer IR-lampe (19,2 $kW/m^2$) und anschliessend 45 Minuten im Umlufttrockner bei 280°C getrocknet. Die Schichtstärke der trockenen Polymerschicht beträgt 30-35 µm. Zwei beschichtete Kupferfolien werden harzseitig aufeinander gelegt und 15 Minuten bei 270°C mit einem Druck von 40-50 $kg/cm^2$ verpresst und unter Druck abgekühlt. Man erhält ein glattes blasenfreies Laminat mit folgenden Eigenschaften.

Kupferhaftung (N/cm) bei:

| | |
|---|---|
| Raumtemperatur (RT) = | 18-20 |
| 150°C = | 16-17 |
| 260°C = | 3,9 |
| NMP-Aufnahme bei RT (%) = | 8. |

c. Herstellung des PA-PI-Blockcopolymeren B

Gemäss Beispiel 1 der EP-A-0 381 620 wird ein Polyimidblock synthetisiert aus120,84 (0,375 Mol) 3,3′,4,4′-Benzophenontetracarbonsäuredieanhydrid und 71,48 g (0,281 Mol) 3,3′-Diethyl-4,4′-diaminodiphenylmethan und ein Polyamidblock synthetisiert aus 57,65 g (0,284 Mol) Isophthalsäuredichlorid und 95,61 g (0,375 Mol) 3,3′-Diethyl-4,4′-diaminodiphenylmethan. Die inh. Viskosität (0,5 Gew.-% Polymeres in NMP bei 25°C) beträgt 0,60 dl/g.

Das getrocknete PA-PI-Blockcopolymere wird in N-Methylpyrroldion gelöst, so dass eine 20 gew.-%ige Lösung resultiert. Diese Lösung wird für die nachfolgend beschriebene Beschichtung verwendet.

d. Herstellung eines Mehrschichtlaminates mit dem PA-PI-Blockcopolymeren B

Auf eine 35 µm starke Kupferschicht aus Elektrolytkupfer wird auf der Behandlungsseite ein Nassfilm von 200 µm der PA-PI-Blockcopolymer-Lösung B aufgetragen. Die Beschichtung wird 1 Stunde bei 230°C im Umluftofen getrocknet, wobei von Raumtemperatur auf 230°C aufgeheizt wird.

Zwei solcherart beschichtete Kupferfolien werden mit der Beschichtung zueinander 2 Minuten bei 280°C mit einem Druck von 40-50 $kg/cm^2$ verpresst und unter Druck auf Raumtemperatur abgekühlt. Es werden folgende Werte für die Haftung ermittelt.

| | |
|---|---|
| RT = | 16 N/cm |
| 150°C = | 13 N/cm |
| 250°C = | 16 N/cm. |

e. Herstellung einer gedruckten Schaltung

Ein gemäss der Vorschrift b. hergestelltes Laminat wird nach bekannten Methoden zu einer zweiseitigen gedruckten flexiblen Schaltung verarbeitet, indem zunächst auf beide Seiten ein Photolack ("Positiv 20" der Fa. Kontakt-Chemie) aufgebracht wird. Der Photolack wird mittels einer Schaltungsvorlage und einer UV-Lampe strukturiert und im wässrig-alkalischen Medium entwickelt. Das ungeschützte Kupfer wird bei 40°C mit Eisen-(III)-chlorid weggeätzt und anschliessend der Photolack mit einer Lösung aus Aceton/Methylethylketon gestrippt. Man erhält eine glatte zweiseitige flexible Schaltung.

## Patentansprüche

1. Mehrschichtlaminate, bestehend aus mindestens zwei Metallfolien, die direkt durch eine Polymerschicht eines Polyamidpolyimid(PA-PI)-Blockcopolymeren verbunden sind.

2. Mehrschichtlaminate gemäss Anspruch 1, worin die Metallfolien aus Kupfer bestehen.

3. Mehrschichtlaminate gemäss Anspruch 1, worin die Polymerschicht aus einem in einem polaren aprotischen Lösungsmittel löslichen PA-PI-Blockcopolymeren besteht.

4. Mehrschichtlaminate gemäss Anspruch 1, worin die Polymerschicht aus einem PA-PI-Blockcopolymer mit einem mittleren Molekulargewicht $\overline{M}_n$ von 1'000 bis 50'000 besteht, das wiederkehrende Einheiten der Formel I

$$\left[PA\text{-}PI\right] \qquad (I)$$

enthält, worin PA für einen Polyamidblock mit einem mittleren Molekulargewicht $\overline{M}_n$ von 300-20'000 steht, enthaltend mindestens eine (wiederkehrende) Einheit der Formel III

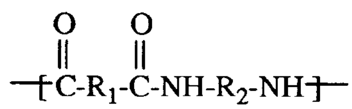 (III),

worin $R_1$ ein Rest der Formeln $-C_nH_{2n}-$,

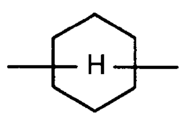 , 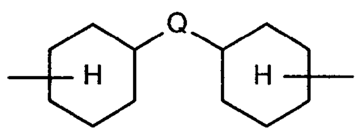 ,

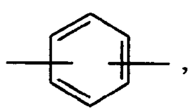 , 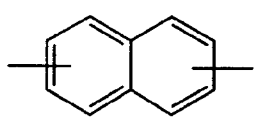

oder

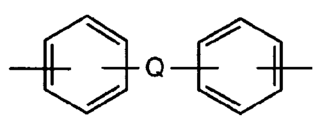 ;

ist, und $R_2$ einen Rest der Formeln $-C_nH_{2n}-$,

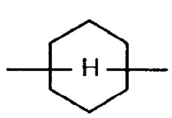 , 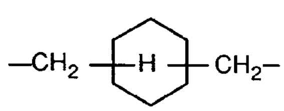 ,

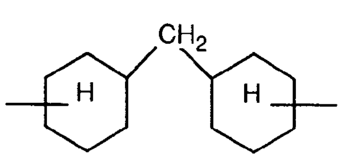 , 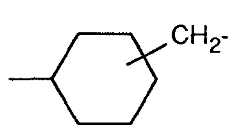 , 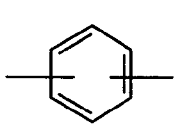 , 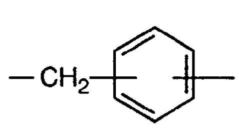 ,

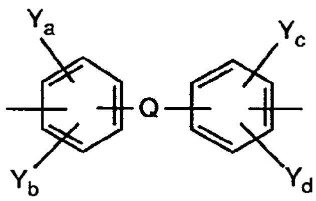
,
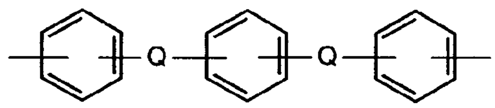
oder

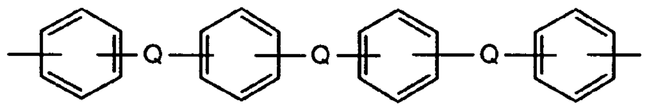

bedeutet, worin Q die direkte Bindung, $-CH_2-$, $-CH_2CH_2-$, $-CH(CH_3)-$, $-C(CH_3)_2-$, $-C(CF_3)-$, -O-, -S-, $-SO_2-$, oder -CO- ist, und n 2-12 ist, und $Y_a$, $Y_b$, $Y_c$ und $Y_d$ unabhängig voneinander Wasserstoff, Halogen oder $C_1$-$C_4$-Alkylen bedeuten, und PI für einen Polyimidblock mit einem mittleren Molekulargewicht $\overline{M}_n$ von 300-20'000 steht, enthaltend mindestens eine (wiederkehrende) Einheit der Formel IV

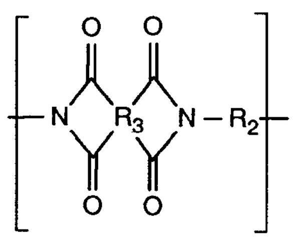
(IV),

worin $R_3$

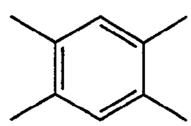
,
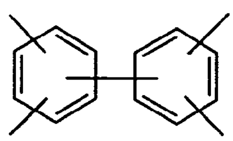

oder

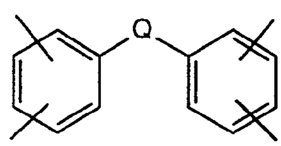

ist, und Q und $R_2$ die oben angegebene Bedeutung haben, mit der Massgabe, dass 25-100 Mol-% aller Brückenglieder $R_2$

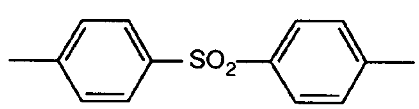

und/oder

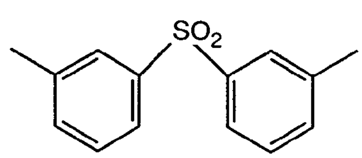

bedeuten, und der (cyclo-)aliphatische Anteil an Brückengliedern $R_2$ nicht mehr als 10 Mol-% beträgt.

5. Mehrschichtlaminate gemäss Anspruch 1, worin die Polymerschicht aus einem PA-PI-Blockcopolymer mit einem $\overline{M}_n$ von 1'000 bis 50'000 besteht das wiederkehrende Struktureinheiten der Formel I enthält

$$\text{⁅}PA\text{-}PI\text{⁆} \quad (I),$$

worin im Polyamidblock PA und im Polyimidblock PI ein Verhältnis von Amid- zu Imidgruppen von etwa 4:1 bis 1:4 vorliegt und das Blockcopolymer in den Polyimidblöcken einen Gehalt von mindestens 2 Mol.%, bezogen auf den Gehalt an allen Carbonsäureresten im Blockcopolymer, an Resten der Formel

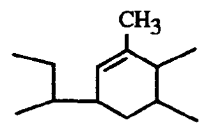

aufweist.

6. Mehrschichtlaminate gemäss Anspruch 5, worin das PA-PI-Blockcopolymer aus Kombinationen von Blöcken der Formeln Vb mit IVa und/oder IVc oder der Formeln IVb mit Va und/oder Vc

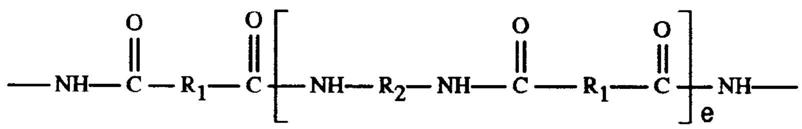 (IVa),

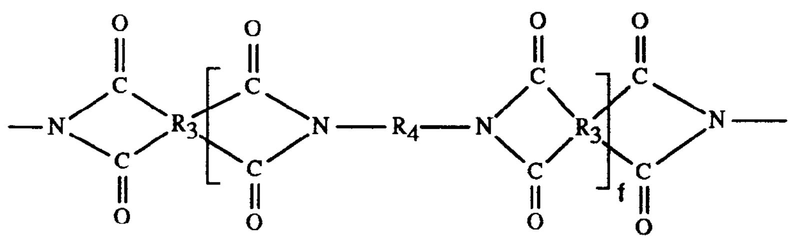 (IVb),

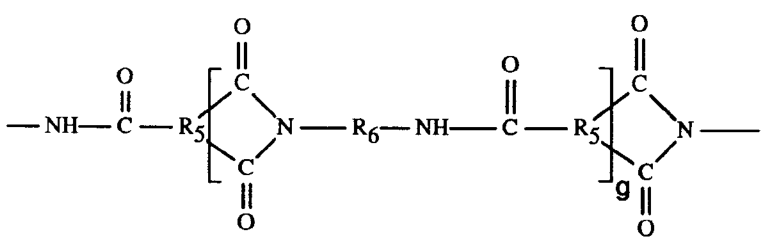 (IVc),

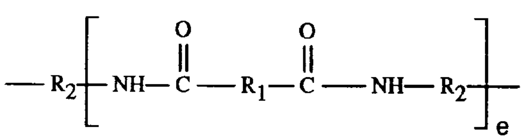 (Va),

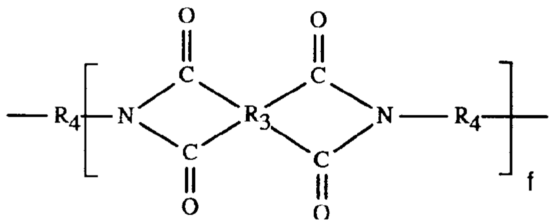

(Vb),

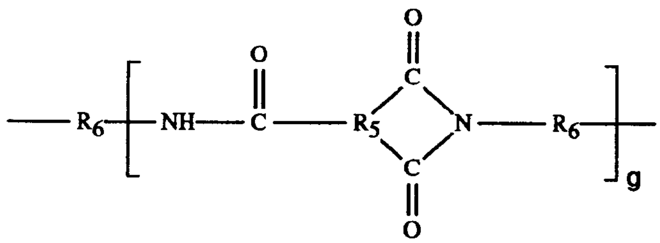

(Vc),

besteht, worin die Indizes e, f und g unabhängig voneinander ganze Zahlen von 1 bis 100 sind, $R_1$ ein Rest der Formeln $-C_nH_{2n}-$,

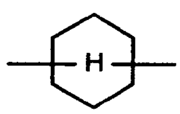 , 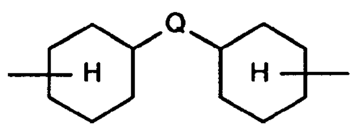 ,

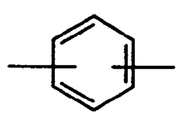 , 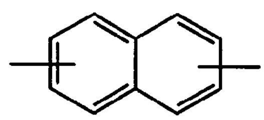

oder

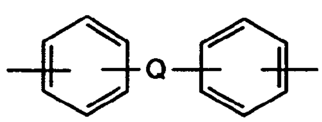

ist, und $R_2$ einen Rest der Formeln $-C_nH_{2n}-$,

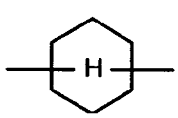 , 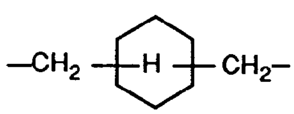 ,

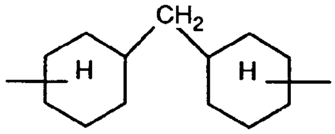 , 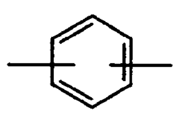 , 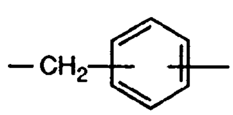 ,

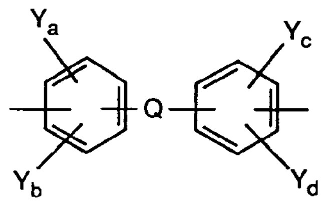, 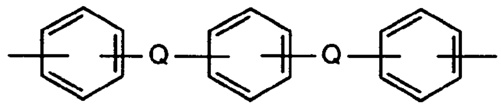

oder

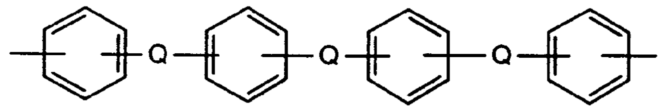

bedeutet, worin Q die direkte Bindung, $-CH_2-$, $-CH_2CH_2-$, $-CH(CH_3)-$, $-C(CH_3)_2-$, $-C(CF_3)-$, -O-, -S-, $-SO_2-$, oder -CO- ist, und n 2-12 ist, und $Y_a$, $Y_b$, $Y_c$ und $Y_d$ unabhängig voneinander Wasserstoff, Halogen oder $C_1$-$C_4$-Alkyl bedeuten, $R_5$ ein Rest der Formeln

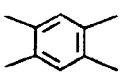, 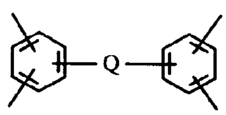, 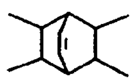, 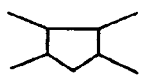 oder 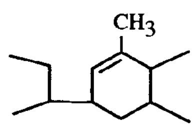 ist,

worin Q eine direkte Bindung darstellt oder $-CH_2-$, $-CH_2CH_2-$, $-CH(CH_3)-$, $-C(CH_3)_2-$, $-C(CF_3)_2-$, -O-, -S-, $-SO_2-$ oder -CO- bedeutet, $R_5$ ein Rest der Formel

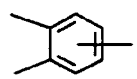

ist, und $R_4$ und $R_5$ unabhängig voneinander eine der für $R_2$ definierten Bedeutungen besitzen, mit der Massgabe, dass 25-100 Mol % aller Reste $R_3$ die Formel

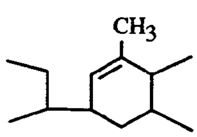

aufweisen.

**7.** Mehrschichtlaminate gemäss Anspruch 5, worin das PA-PI-Blockcopolymer aus Kombinationen von Blöcken der Formeln IVa mit Vb und/oder Vc oder der Formeln IVb mit Va und/oder Vc oder der Formeln IVc mit Va und/oder Vb bestehen, mit der anderen Massgabe, dass 10-100 Mol %, bevorzugt 25-100 Mol %, insbesondere 50-100 Mol %, aller Reste $R_2$, $R_4$ und $R_5$, bezogen auf die Gesamtmenge dieser Reste die Formel

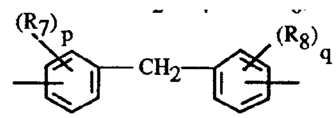

aufweisen, worin p 1 oder 2 und q Null, 1 oder 2 ist, $R_7$ und $R_8$ je ein $C_1$-$C_8$-Alkyl bedeuten oder worin je zwei zueinander ortho-ständige Reste $R_7$ und $R_8$ jeweils zusammen eine Alkylengruppe bilden.

**8.** Mehrschichtlaminate gemäss Anspruch 5, worin das PA-PI-Blockcopolymer aus Kombinationen von Blöcken der Formeln IVa mit Vb und/oder Vc oder der Formeln IVb mit Va und/oder Vc oder der Formeln IVc mit Va und/oder Vb besteht, mit der anderen Massgabe, dass 25-100 Mol % aller Reste $R_2$, $R_4$ und $R_6$, bezogen auf die Gesamtmenge dieser Reste, die Formel

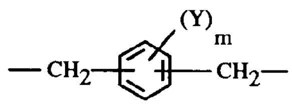

und/oder

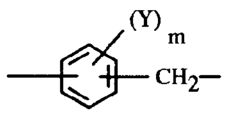

aufweisen, worin Y ein $C_1$-$C_8$-Alkyl oder Halogen bedeutet und m für eine Zahl von 0 bis 4 steht.

**9.** Verfahren zur Herstellung von Mehrschichtlaminaten gemäss Anspruch 1, dadurch gekennzeichnet, dass man eine mit einem PA-PI-Blockcopolymer beschichtete Metallfolie mit einer unbeschichteten Metallfolie oder mit einer oder mehreren mit einem PA-PI-Blockcopolymer beschichteten Metallfolien unter Druck zwischen 180 bis 350°C verpresst.

**10.** Verfahren gemäss Anspruch 9, dadurch gekennzeichnet, dass man zwei einseitig mit einem PA-PI-Blockcopolymer beschichtete Metallfolien mit der beschichteten Seite zueinander unter Druck zwischen 180 und 350°C verpresst.